# EUROPEAN PATENT SPECIFICATION

(11) **EP 2 841 733 B1**
(45) Date of publication and mention of the grant of the patent: **23.05.2018**
(21) Application number: 13718357.0
(22) Date of filing: 08.04.2013
(51) Int. Cl.: F01N 13/18, F01N 13/00, B60R 13/08

(54) **AN EMISSIONS CLEANING MODULE COMPRISING AN OUTLET MODULE**
ABGASREINIGUNGSMODUL MIT EINEM AUSLASSMODUL
MODULE DE PURIFICATION D'ÉMISSIONS COMPORTANT UN MODULE DE SORTIE

(30) Priority: 24.04.2012 GB 201207201
(43) Date of publication of application: 04.03.2015
(73) Proprietor: Perkins Engines Company Limited, Cambridgeshire PE1 5FQ (GB)
(72) Inventor: NIAZ, Naseer, Peterborough Cambridgeshire PE1 4RD (GB)
(74) Representative: BRP Renaud & Partner mbB Rechtsanwälte Patentanwälte Steuerberater
(86) International application number: PCT/GB2013/050902
(87) International publication number: WO 2013/160655

(56) References cited:
- EP-A1- 2 119 885
- EP-A2- 1 262 644
- JP-A- 2011 132 855

## Description

### Technical Field

The disclosure relates to an apparatus for cleaning exhaust fluids emitted during the operation of combustion engines. In particular, it relates to an outlet module for an emissions cleaning module as well as an emissions cleaning module comprising said outlet module.

### Background

Engines, for example IC engines burning gasoline, diesel or biofuel, output various harmful substances which must be treated to meet current and future emissions legislation. Most commonly those substances comprise hydrocarbons (HC), carbon monoxides (CO), mono-nitrogen oxides (NOₓ) and particulate matter, such as carbon (C), a constituent of soot. Some of those substances may be reduced by careful control of the operating conditions of the engine, but usually it is necessary to provide apparatus, such as an emissions cleaning module, downstream of the engine to treat at least some of those substances entrained in the exhaust fluid. Various apparatus for reducing and/or eliminating constituents in emissions are known. For example, it is known to provide an oxidation device, such as a diesel oxidation catalyst, to reduce or to eliminate hydrocarbons (HC) and/or carbon monoxide (CO). Oxidation devices generally include a catalyst to convert those substances into carbon dioxide and water, which are significantly less harmful. As a further example, emissions cleaning modules may include a particulate filter to restrict the particulates present in the exhaust gas from being output to atmosphere.

By use of an emissions cleaning module, engine emissions can be cleaned, meaning that a proportion of the harmful substances which would otherwise be released to atmosphere are instead converted to carbon dioxide (CO₂), nitrogen (N₂) and water (H₂O).

In addition, it is known to reduce or eliminate mono-nitrogen oxides (NO_{X}) in diesel combustion emissions by conversion to diatomic nitrogen (N₂) and water (H₂O) by catalytic reaction with chemicals such as ammonia (NH₃) entrained in the exhaust gas.

Generally ammonia is not present in exhaust fluids and must therefore be introduced upstream of a catalyst, typically by injecting a urea solution into the exhaust gas which decomposes into ammonia at sufficiently high temperatures.

By these methods, engine fluids can be cleaned, meaning that a proportion of the harmful substances which would otherwise be released to atmosphere are instead converted to carbon dioxide (CO₂), nitrogen (N₂) and water (H₂O).

Typically, an outlet of the emissions cleaning module may be connected as part of an exhaust arrangement. The exhaust arrangement may comprise the emissions cleaning module and an exhaust pipe which may be connected to the emissions cleaning module. Other components, for example, engine hoods, may form a part of the exhaust arrangement. Different engines and different installations (vehicular or static) may require different configurations and may place different space constraints on the exhaust arrangement.

US2011/0284308 describes an exhaust system including an exhaust gas treatment unit to which an outlet pipe is connected such that the outlet pipe extends alongside a main chamber of the exhaust gas treatment unit to reduce the overall length of the exhaust gas treatment unit. JP2011132855 & EP2119885 disclose emissions cleaning modules. Against this background there is provided an improved outlet module for an emissions cleaning module of a combustion engine.

### Summary of the disclosure

The present disclosure provides an emissions cleaning module for a combustion engine according to the features of claim 1. The present disclosure also provides an exhaust arrangement comprising the emissions cleaning module just described and a section of external pipework, wherein the section of external pipework is mounted to the outlet module in a cantilevered manner without other physical support.

### Brief description of the drawings

Embodiments of the present disclosure will now be described, by way of example only, with reference to the accompanying drawings in which:
Figure 1 shows an emissions cleaning module in accordance with the present disclosure;
Figure 2 shows a support frame of the emissions cleaning module of Figure 1;
Figure 3 shows a cross-section through a portion of the emissions cleaning module of

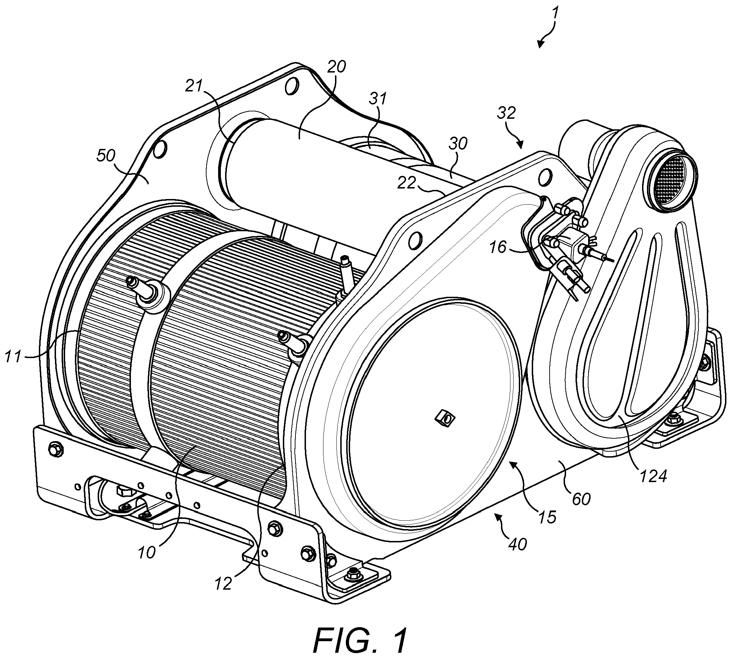

Figure 1 also showing an end plate heat shield in place on the emissions cleaning module;

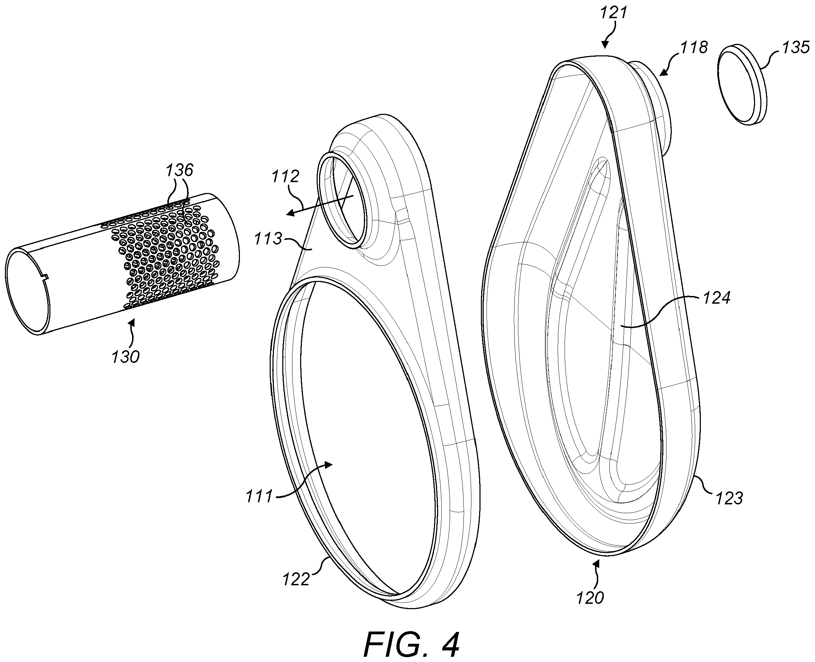

Figure 4 is an exploded perspective view of an outlet module of the emissions cleaning module of Figure 1;

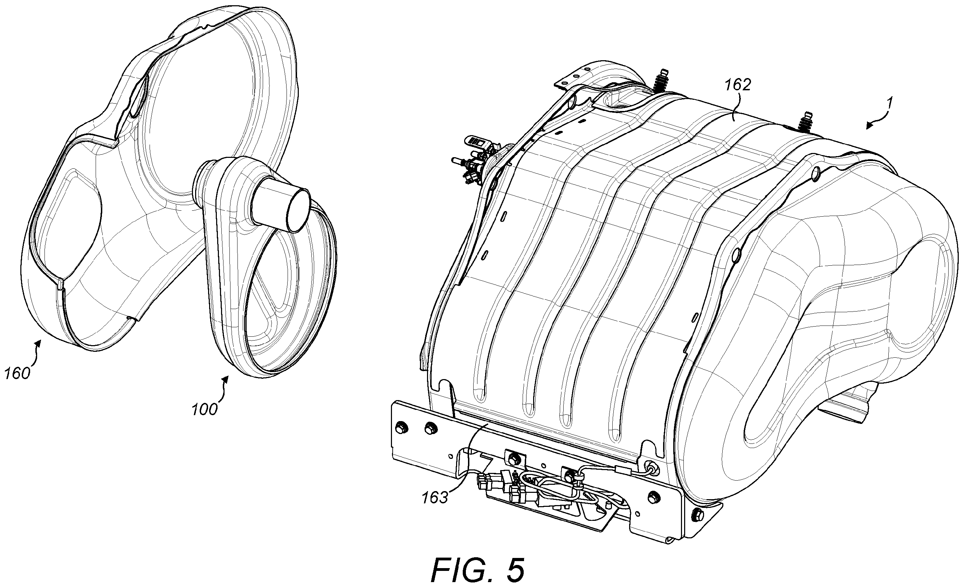

Figure 5 is an exploded perspective view of the emissions cleaning module and its outlet module and end plate heat shield;

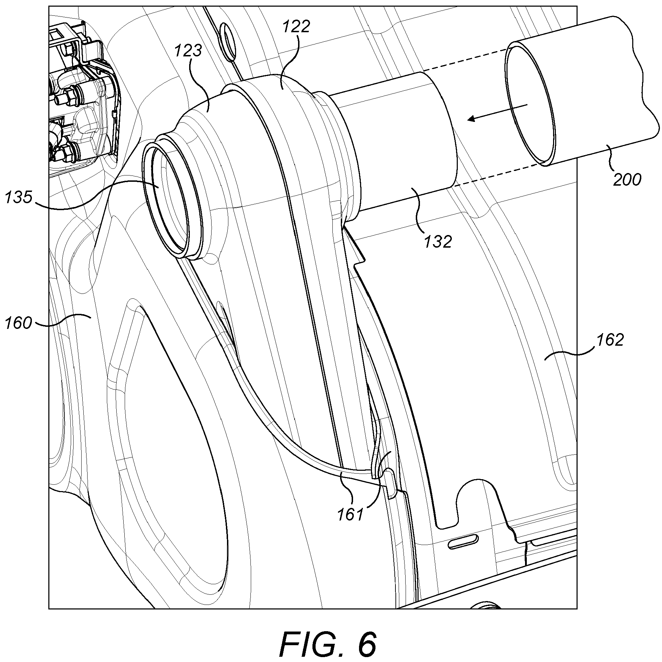

Figure 6 is a perspective view of the emissions cleaning module of Figure 1 showing attachment of a section of external pipework;

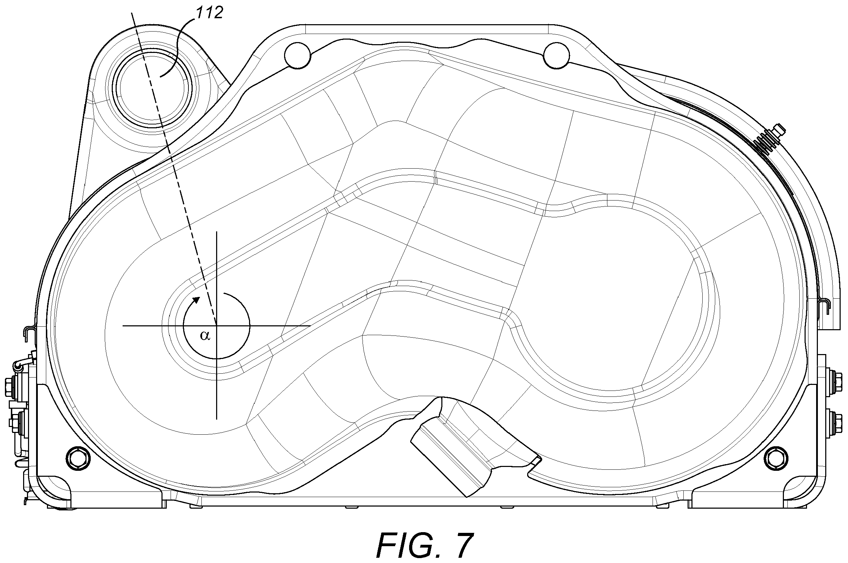

Figure 7 is an end view of the emissions cleaning module of Figure 1 illustrating the angular orientation of the outlet module;

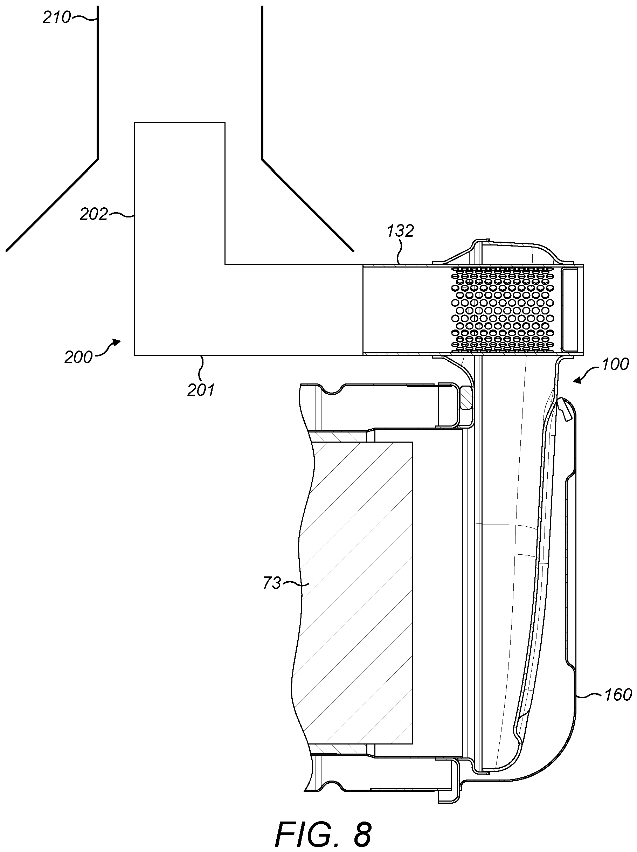

Figure 8 is a cross-sectional view of a portion of the emissions cleaning module of Figure 1 with a section of external pipework fitted thereto and showing an adjacent engine hood;

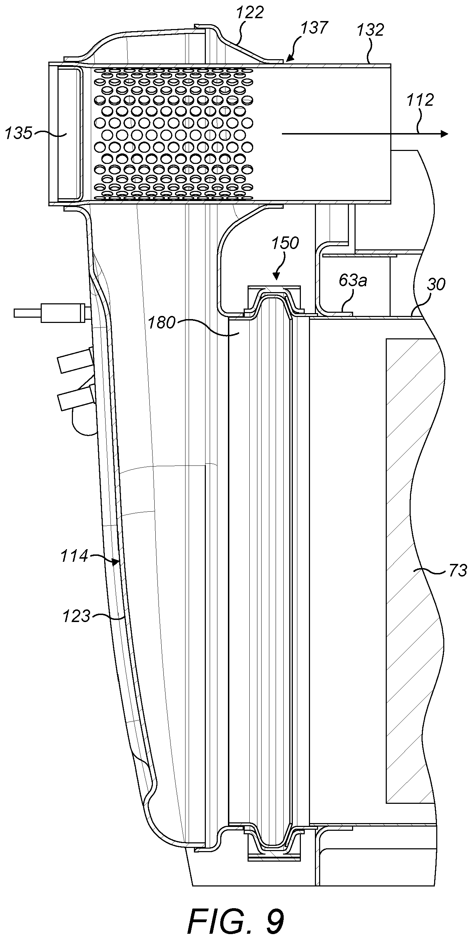

Figure 9 is a cross-sectional view of a second embodiment of outlet module for the emissions cleaning module of Figure 1;

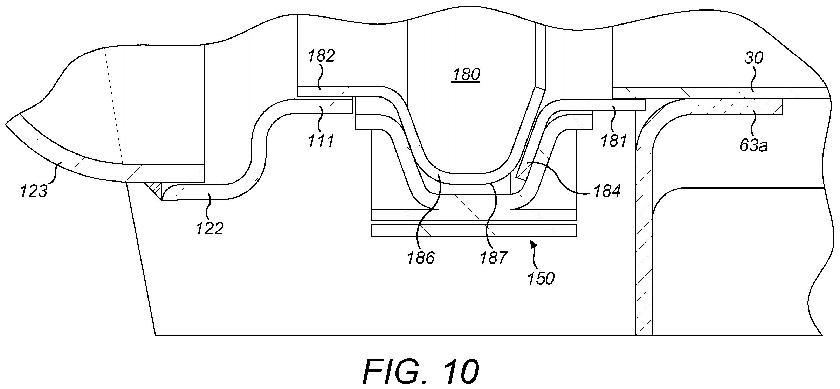

Figure 10 is an enlarged cross-sectional view of a portion of Figure 9;

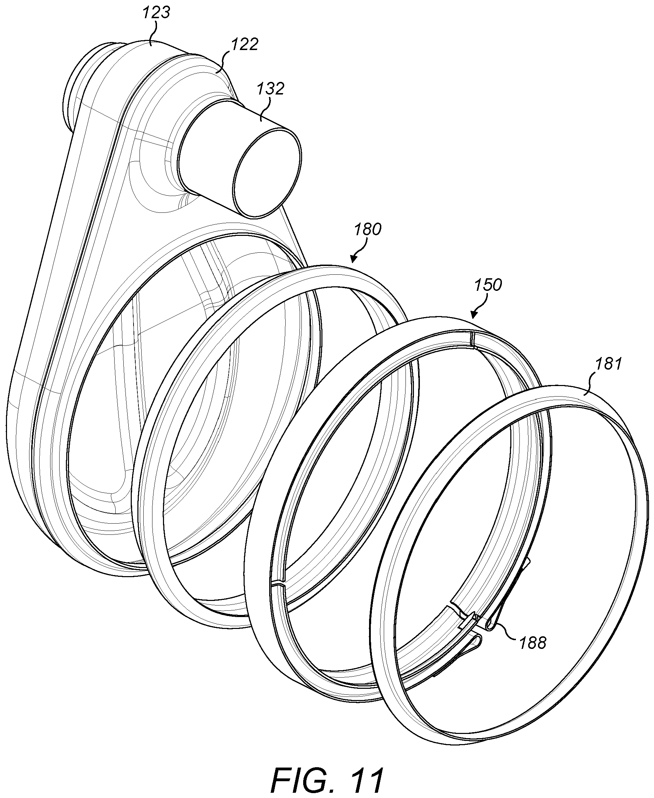

Figure 11 is an exploded perspective view of the outlet module of Figure 9; and

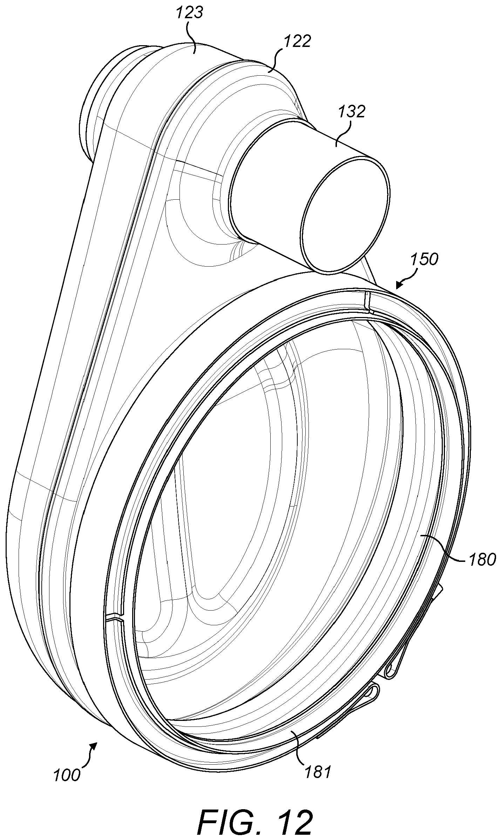

Figure 12 is a perspective view of the outlet module of Figure 9.

### Detailed description

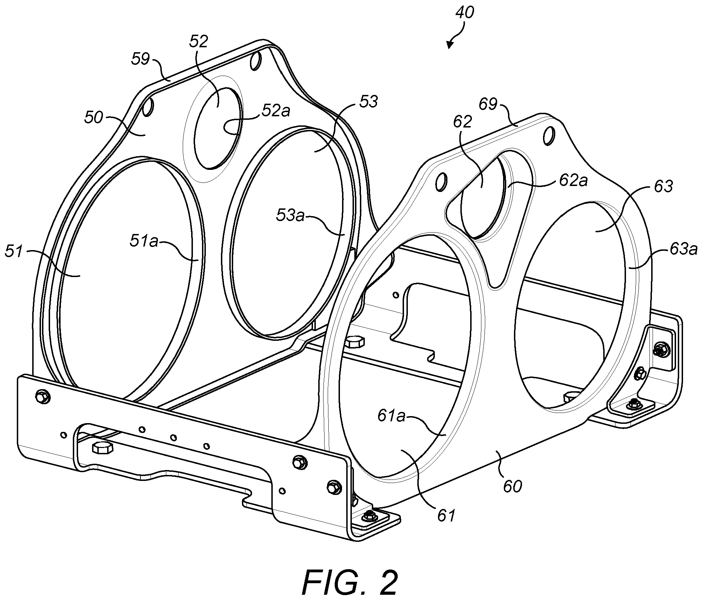

The general structure of an example of the emissions cleaning module 1, is shown in Figure 1, and may comprise a first conduit 10 and a second conduit 20. A third conduit 30 and a support structure 40 may also be present. The support structure 40, as shown in Figure 2, may comprise a first support member 50 and a second support member 60.

Each support member 50, 60 may be generally planar and may be of rigid material, for example metal.

The first, second and third conduits 10, 20, 30 may be elongate, having an axis of elongation, and may have a substantially constant cross-section along the axis of elongation. The first, second and third conduits 10, 20, 30 may be substantially cylindrical.

The first conduit 10 may comprise a first end 11 providing an inlet to the conduit and a second end 12 providing an outlet to the conduit. The second conduit 20 may comprise a first end 21 providing an outlet to the conduit and a second end 22 providing an inlet to the conduit. The third conduit 30 may comprise a first end 31 providing an inlet to the conduit and a second end 32 providing an outlet to the conduit.

The first, second and third conduits 10, 20, 30 may extend between the support members 50, 60. The first, second and third conduits 10, 20, 30 may be generally substantially parallel. The first ends 11, 21, 31 of the first, second and third conduits 10, 20, 30 may be received in and may be shaped to correspond with first, second and third openings 51, 52, 53, respectively, of the first support member 50. The second ends 12, 22, 32 of the first, second and third conduits 10, 20, 30 may be received in and may be shaped to correspond with first, second and third openings 61, 62, 63, respectively, of the second support member 60. By this arrangement, lateral movement of the conduits may be restricted.

As shown in Figure 2, each opening 51, 52, 53, 61, 62, 63 may comprise a flange 51a, 52a, 53a, 61a, 62a, 63a extending around a perimeter of the opening. Each support member 50, 60 may further comprise an inwardly turned lip 59, 69 extending at least part way around a periphery of the support member 50, 60.

The first, second and third conduits 10, 20, 30 may all be of substantially similar length. The first conduit 10 may have a first diameter, the second conduit 20 may have a second diameter and the third conduit 30 may have a third diameter. The second diameter may be smaller than the first and third diameters.

The first and second ends 11, 21, 31, 12, 22 of the first, second and third conduits 10, 20, 30 may be welded, adhered or otherwise secured to portions of the support members 50, 60 defining or surrounding the openings. Alternatively, first and second ends 11, 21, 31, 12, 22, 32 of the first, second and third conduits 10, 20, 30 may abut the inner sides of the support members 50, 60 so as to overlie respective openings in the support members 50, 60.

The first, second and third conduits 10, 20, 30 and the first and second support members 50, 60 may be interconnected in a manner which restricts relative translational movement of those components. Instead or in addition, the first, second and third conduits 10, 20, 30 and the first and second support members 50, 60 may be interconnected in a manner which restricts rotational movement of one component with respect to another.

The first conduit 10 may be fluidly coupled to the second conduit 20 via a first end coupling 15 which may fluidly connect the outlet of the first conduit 10 to the inlet of the second conduit 20. The second conduit 20 may be coupled to the third conduit 30 via a second end coupling 25 for fluidly connecting the outlet of the second conduit 20 to the inlet of the third conduit 30. Each of the first and second end couplings may define, in combination with its respective support member, a fluid flow path through which exhaust fluid, for example exhaust gas, may pass between adjacent conduits.

Within the fluid flow path of the emissions cleaning module 1 there may be located a diesel oxidation catalyst (DOC) module 71, a diesel particulate filter (DPF) module 70, a selective catalyst reduction (SCR) module and an ammonia oxidation catalyst (AMOX) module 73. The fluid flow path is also provided with a mixing conduit and an injector module 16, the function of which will be described further below.

The DOC module 71 may be located in a first portion of the first conduit 10 towards the first end 11, forming the inlet of the first conduit 10. The DPF module 70 may be located in a second portion of the first conduit 10 towards the second end 12 forming the outlet of the first conduit 10. The first end coupling 15 may provide a fluid flow path from the second end 12 of the first conduit 10 to the second end 22 of the second conduit 20.

The SCR module may be located in a first portion of the third conduit 30 towards the first end 31 of the third conduit 30. The SCR module may comprise a catalyst surface intended to catalyse a reaction to occur between the two fluids mixed in the mixing conduit and output by the diffuser. The AMOX module 73 may both be located in a second portion of the third conduit 30 towards the second end 32 of the third conduit 30. The AMOX module 73 may comprise a catalyst which may catalyse a reaction of one or more of the products output from the SCR module.

The mixing conduit 75 may be located in, or formed by, the second conduit 20.

As shown in Figure 1, the injector module 16 is located upstream of the inlet of the mixing conduit with an outlet of the injector module 16 being orientated to inject an additive into the inlet of the mixing conduit. The injector module 16 may be mounted in the first end coupling 15.

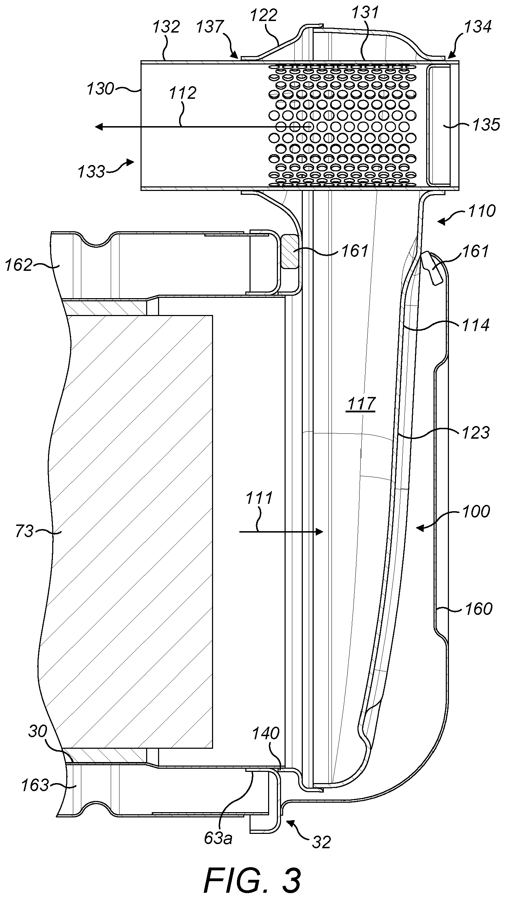

In use, fluid, for example exhaust gases, may be supplied to the emissions cleaning module 1 via an inlet 4 as shown in Figure 3. Fluid may pass into the DOC module 71 in the first portion of the first conduit 10. Prior to receipt at the inlet 4, the pressure of the fluid may be controlled by a back pressure valve.

The DOC module 71 may comprise one or more catalysts, such as palladium or platinum. These materials serve as catalysts to cause oxidation of hydrocarbons ([HC]) and carbon monoxide (CO) present in the fluid flow in order to produce carbon dioxide (CO₂) and water (H₂O). The catalysts may be distributed in a manner so as to maximise the surface area of catalyst material in order to increase effectiveness of the catalyst in catalysing reactions.

Fluid may flow from the DOC module 71 to the DPF module 70 which comprises features which are intended to prevent onward passage of carbon (C) in the form of soot. Carbon particles in the fluid may thus trapped in the filter. The filter may be regenerated through known regeneration techniques. These techniques may involve controlling one or more of the temperature of the fluid, the pressure of the fluid and the proportion of unburnt fuel in the fluid.

Fluid may pass from the DOC module 71 past the injector module 16 located within the first end coupling 15. The injector module 16 may be associated with or attachable to a pump electronic tank unit (PETU). The pump electronic tank unit may comprise a tank for providing a reservoir for additive fluid to be injected by the injector. Such additive fluids may include urea or ammonia.

The PETU may further comprise a controller configured to control a volume of additive fluid to be injected from the tank by the injector. The controller may have as inputs, for example, temperature information and quantity of NOx information which may be derived from sensors in the SCR module.

Fluid may pass the injector module 16 where it may receive the injected additive fluid and the resultant mixture of exhaust fluid and additive fluid then passes into the mixing conduit via the inlet.

From the mixing conduit fluid may then pass via the second end coupling 25 into the SCR module located in the first portion of the third conduit 30 via the second end coupling 25. The SCR module may comprise one or more catalysts through which the mixture of exhaust fluid and urea/ammonia may flow. As the mixture passes over the surfaces of the catalyst a reaction may occur which converts the ammonia and NOx to diatomic nitrogen (N₂) and water (H₂O).

Fluid may pass from the SCR module to the AMOX module 73 located in the second portion of the third conduit 30. The AMOX module 73 may comprise an oxidation catalyst which may cause residual ammonia present in the fluid exiting the SCR module to react to produce nitrogen (N₂) and water (H₂O).

Fluid may then pass from the AMOX module 73 to an outlet module 100 of the emissions cleaning module 1 located at the second end 32 of the third conduit 30.

A first embodiment of outlet module 100 is illustrated in Figure 3. The outlet module 100 comprises a housing 110 defining an outlet chamber 117 and which is provided with a first aperture 111 forming an inlet and a second aperture 112. Both the first aperture 111 and the second aperture 112 may be provided in a first face 113 of the housing 110. The first aperture 111 may be sized for connection to the emissions cleaning module 1. As shown in Figure 3, the first aperture 111 may be connected to the second end 32 of the third conduit 30. As noted above, the AMOX module 73 may be located at or towards the second end 32 of the third conduit 30.

The housing 110 may have a tapered shape defining a large end 120 and a small end 121 as most clearly seen in Figure 4. The first aperture 111 may be located at the large end 120 and the second aperture 112 may be located at the small end 121.

A tubular member 130 is mounted in the second aperture 112 of the housing 110 as shown in Figure 3. The tubular member 130 may be elongate. The tubular member 130 is mounted in the second aperture 112 such that an internal portion 131 of the tubular member 130 is located within the housing 110 and an external portion 132 of the tubular member 130 extends from the housing 110 in a cantilevered manner. The tubular member 130 defines the outlet 133 of the outlet module 100.

The internal portion 131 of the tubular member 130 may comprise a plurality of apertures 136 which in use may allow for conveyance of a fluid from outside the tubular member 130 into an interior of the tubular member 130.

The housing 110 may be formed from a first cover member 122 and a second cover member 123 which may be connected together to define the outlet chamber 117 of the outlet module 100. The first cover member 122 may define both the first aperture 111 and the second aperture 112 of the housing 110. The first aperture 111 and the second aperture 112 may both face in the same direction. The second cover member 123 may be provided with a W-shaped stiffening groove 124 as shown in Figures 1 and 4 which may increase the structural rigidity of the outlet module 100. Other shapes of stiffening groves are also contemplated within the scope of the disclosure. For example, the second cover member 123 may be provided with a U-shaped grove or two spaced-apart U-shaped grooves which may increase the structural rigidity of the outlet module 100.

The first cover member 122 and the second cover member 123 may be connected together by a suitable mechanism. For example, the first cover member 122 and the second cover member 123 may be welded together. Further, the tubular member 130 may be welded to the first cover member 122 at a joint 137 at the location of the second aperture 112.

The tubular member 130 may extend within the housing 110 into a mounting contact with the second cover member 123. The second cover member 123 may comprise an aperture 118 which may receive the tubular member 130 so as to mount the tubular member 130 to the second cover member 123. A welded connection between the second cover member 123 and the tubular member 130 may be provided.

A first end of the tubular member 130 may form an open end which in use allows fluid flow therethrough. An opposed second, closed end 134 of the tubular member 130 may be closed off by an end cap 135 as shown in Figure 3. The open end may form the outlet 133 of the outlet module 100.

The housing 110 may comprise a mounting flange 140 for connecting the outlet module 100 to the emissions cleaning module 1. As shown in Figure 3, the mounting flange 140 may be connected to the second end 32 of the third conduit 30. The connection may be by means of a weld. As noted above, the second end 32 of the third conduit 30 may be welded to the flange 63a of the second support member 60. In addition, the mounting flange 140 of the outlet module 100 may be welded to the second support member 60 in addition, or alternatively to welding to the third conduit 30.

As shown in Figure 5, the emissions cleaning module 1 may be provided with a top body heat shield 162 and a bottom body heat shield 163 which may overlie the third conduit 30 as well as other components of the emissions cleaning module 1. The emissions cleaning module 1 may also comprise an end plate heat shield 160 which may overlie at least a portion of the outlet module 100 as shown in Figures 3 and 6. Wire mesh 161 may be provided to fill any gaps between the end plate heat shield 160 and the outlet module 100. In addition, wire mesh 161 may be provided to fill any gaps between the second support member 60 and the outlet module 100, as shown in Figure 6. The wire mesh 161 may function to prevent debris entering and collecting within void spaces. The wire mesh 161 may act as a flexible heat-resistant component that can expand and contract with the surrounding components.

Figure 4 illustrates the components of the outlet module 100 prior to assembly. Assembly of the outlet module 100 and connection of the outlet module 100 to the emissions cleaning module 1 may take place as follows:
1. Firstly, the tubular member 130 may be inserted through the second aperture 112 of the first cover member 122.
2. Next, a welded connection may be formed between the tubular member 130 and the first cover member 122 to form a sub-assembly.
3. Next, the sub-assembly of the tubular member 130 and the first cover member 122 may be connected to the second end 32 of the third conduit 30 and an internal welded connection therebetween may be formed. At this point, access for forming the weld between the first cover member 122 and the third conduit 30 may be from the inside, i.e. through the open rear face of the first cover member 122.
4. Next, the second cover member 123 may be mounted to the first cover member 122 and an external welded connection therebetween may be formed.
5. Next, a welded connection between the second cover member 123 and the closed end 134 of the tubular member 130 may be formed.
6. Finally, the end cap 135 may be positioned in the tubular member 130 and welded thereto.

Thereafter, the end plate heat shield 160 may be mounted to the emissions cleaning module 1. As shown in Figure 6, with the end plate heat shield 160 mounted, at least the small end 121 of the outlet module 100 may project externally of the end plate heat shield 160 to allow fitting of a section of external pipework 200 to the tubular member 130.

The outlet module 100 may be connected to the third conduit 30 with the tubular member 130 located at various angular positions about the longitudinal axis A of the third conduit 30. As shown in Figure 7, the angular position of the tubular member 130 may be defined as the angle α subtended in a clockwise direction from a vertical line passing through the longitudinal axis A to a line extending from the longitudinal axis A and passing through a centre of the tubular member 130. The angle α as illustrated is measured in the clockwise direction about the longitudinal axis A when viewed in the orientation shown in Figure 7 - that is from the first support member 50 towards the second support member 60.

The angle α as illustrated in Figure 7 is 345°. Other angles may be chosen, for example angle α may be 300° or 330°.

Varying the angle α may allow for more ready adaption of the emissions cleaning module 1 and outlet module 100 to the space constraints that may be set by the overall exhaust arrangement in which the emissions cleaning module 1 is to form a part.

Figure 8 illustrates one example of exhaust arrangement incorporating the emissions cleaning module 1 and the outlet module 100 of the present disclosure. As illustrated, a section of external pipework 200 has been mounted to the external portion 132 of the tubular member 130. In this example, the section of external pipework 200 has an L-shaped form having an axially extending section 201 and a dog-legged section 202 extending at 90 ° to the axially extending section 201. The exhaust arrangement may further comprise other unconnected components, such as an engine hood venturi 210.

The section of external pipework 200 connected to the outlet module 100 may be fully supported by the connection to the tubular member 130. The connection to the tubular member 130 may be an interference fit, a sliding fit, a releasably clamped connection or a permanent connection, e.g. welded.

In use, fluid enters the outlet chamber 117 of the outlet module 100 from the second end 32 of the third conduit 30 as most clearly seen in Figure 3. The fluid flow is diverted to pass through the apertures 136, thereby conveying the fluid into the interior of the tubular member 130. The end cap 135 prevents fluid exiting the tubular member 130 to the right as shown in the orientation of Figure 3. Rather fluid is diverted out of the outlet 133 into the section of external pipework 200 (not shown in Figure 3). Between entering through the first aperture 111 and exiting through the second aperture 112 within the tubular member 130 the fluid may be diverted through 180°.

Figures 9 to 12 illustrate a second embodiment of outlet module 100 according to the present disclosure. Like components between the second embodiment and the first embodiment have been referenced using like numerals and only the differences between the embodiments will be described in further detail.

As illustrated in Figure 9, the second embodiment of outlet module 100 may be connected to the third conduit 30 of the emissions cleaning module 1 by means of a releasable mechanism, for example a clamping mechanism, rather than by a permanent welded connection. As shown in Figure 11, the clamping mechanism may comprise a clamping member 150, an adaptor ring 180 and a mounting ring 181.The mounting ring 181 may be fastened to the third conduit 30 as shown in Figure 10 by means of a welded connection. The mounting ring 181 may comprise a flange 184 at a distal end from the third conduit 30. The adaptor ring 180 may be fastened to the first aperture 111 of the first cover member 122 by means of a welded connection which may be formed between a ring portion 182 of the adaptor ring 180 and the first aperture 111 of the first cover member 122. A distal end of the adaptor ring 180 may comprise a portion 186 of enlarged diameter as shown in Figure 10.

The clamping member 150 may comprise a band clamp, such as a Marman clamp, which may comprise an annular cavity 187 and a fastening mechanism 188 by which the circumference of the band clamp can be adjusted.

In use, the outlet module 100 of the second embodiment may be assembled by first mounting the tubular member 130 to the first cover member 122 as described previously. The adaptor ring 180 may then be fastened to the first cover member 122 by welding. Thereafter, the second cover member 123 may be fastened to the first cover member 122, the tubular member 130 may be fastened to the second cover member 123 and the end cap 135 may be fastened as described previously. Separately, the mounting ring 181 may be welded to the second end 32 of the third conduit 30.

In order to mount the outlet module 100, the fastening mechanism 188 of the clamping member 150 may be loosened to increase the circumference of the band clamp, the enlarged diameter portion 186 of the adaptor ring 180 abutted up against the flange 184 of the mounting ring 181 and the fastening mechanism 188 of the clamping member 150 re-fastened as shown in Figure 10 to clamp the adaptor ring 180 to the mounting ring 181.

As with the first embodiment, the clamping mechanism allows for the second aperture 112 of the outlet module 100 to be located at a varying angle α about the longitudinal axis A of the third conduit 30.

Fluid flow through the second embodiment of outlet module 100 is as described above in connection with the first embodiment.

### Industrial Applicability

The present disclosure provides an improved outlet module for an emissions cleaning module of a combustion engine, and an emissions cleaning module comprising such an outlet module. The emissions cleaning module may be used to treat fluids produced by IC engines burning gasoline, diesel or biofuel so as to reduce or eliminate various harmful substances which must be treated to meet current and future emissions legislation. The outlet module may allow for a more compact exhaust arrangement and, in particular, may allow for improved connection of external pipework to the outlet module. The outlet module may allow greater flexibility in the location of the point of connection with the external pipework. In addition, the outlet module may provide for the cantilevered support of a section of the external pipework which may remove the need to provide any additional physical support to said section of the external pipework. The outlet module may also allow for easier fitting and removal of the outlet module from the emissions cleaning module which may improve the efficiency of maintaining the emissions cleaning module.

## Claims

1. An emissions cleaning module (1) for a combustion engine, the emissions cleaning module comprising an outlet module (100) having an outlet (133) providing an exit for fluid from the emissions cleaning module (1), the outlet module (100) comprising:
i) a housing (110) formed from a first cover member (122) and a second cover member (123) connected together to define an outlet chamber (117), the first cover member (122) of the housing (100) being provided with a first aperture (111) forming an inlet of the outlet module and a second aperture (112); and the second cover member (123) being provided with a third aperture (118); and
ii) a tubular member (130) forming an outlet of the outlet module; wherein the tubular member (130) is mounted in the second aperture (112) such that:
an internal portion (131) of the tubular member (130) is located within the outlet chamber (117) and into a mounting contact with the second cover member wherein it is received within the third aperture (118); and
an external portion (132) of the tubular member (130) extends from the housing (100) in a cantilevered manner; and
wherein the internal portion (131) of the tubular member (130) comprises a plurality of apertures (136) for conveying a fluid flow into an interior of the tubular member (130) and wherein the plurality of apertures is distributed both (a) around a circumference of the internal portion (131) of the tubular member (130) and (b) along an axial length of the internal portion (131) of the tubular member (130)
wherein the tubular member (130) comprises a first open end (133) forming the outlet and a second end (134) that is closed by an end cap (135) the prevents fluid exiting the tubular member (130).

2. The emissions cleaning module (1) as claimed in claim 1, wherein the housing (110) has a tapered shape defining a large end and a small end; wherein the first aperture (111) is located at the large end and the second aperture (112) is located at the small end.

3. The emissions cleaning module (1) as claimed in claim 1 or claim 2, wherein both the first aperture (111) and the second aperture (112) are provided in a first face of the housing (110).

4. The emissions cleaning module (1) as claimed in any preceding claim further comprising a clamping member (150) for clamping the outlet module to an emissions cleaning module (1).

5. The emissions cleaning module (1) as claimed in any preceding claim wherein the housing (110) comprises one or more of:
(a) a W-shaped stiffening groove (124);
(b) a U-shaped stiffening groove; and
(c) a pair of spaced-apart U-shaped stiffening grooves.

6. The emissions cleaning module (1) as claimed in any preceding claim wherein the housing (110) comprises a mounting flange (140) which is welded to the emissions cleaning module (1).

7. The emissions cleaning module (1) as claimed in any preceding claim further comprising a clamping member (150) which clamps the outlet module (100) to the emissions cleaning module (1).

8. The emissions cleaning module (1) as claimed in any preceding claim further comprising a further tubular member connected at the outlet of the housing, wherein the further tubular member is orientated parallel to a conduit (10, 20, 30) of the emissions cleaning module (1).

9. The emissions cleaning module (1) as claimed in any preceding claim wherein a heat shield (160) is located on the emissions cleaning module (1) overlying the outlet module (100); and wherein a portion of the outlet module (100), including at least a portion of the tubular member (130), projects to the exterior of the heat shield (160).

10. An exhaust arrangement comprising the emissions cleaning module (1) of any of preceding claim and a section of external pipework, wherein the further tubular member is mounted to the outlet module (100) in a cantilevered manner without other physical support.

## Patentansprüche

1. Emissionsreinigungsmodul (1) für einen Verbrennungsmotor, wobei das Emissionsreinigungsmodul ein Auslassmodul (100) umfasst, das einen Auslass (133) aufweist, der einen Auslass für Flüssigkeit aus dem Emissionsreinigungsmodul (1) bereitstellt, wobei das Auslassmodul (100) Folgendes umfasst:
i) ein Gehäuse (110), das aus einem ersten Abdeckelement (122) und einem zweiten Abdeckelement (123) gebildet ist, die miteinander verbunden sind, um eine Auslasskammer (117) zu definieren, wobei das erste Abdeckelement (122) des Gehäuses (100) mit einer ersten Öffnung (111) versehen ist, die einen Einlass des Auslassmoduls und eine zweite Öffnung (112) bildet; und das zweite Abdeckelement (123) mit einer dritten Öffnung (118) versehen ist; und
ii) ein röhrenförmiges Element (130), das einen Auslass des Auslassmoduls bildet;
wobei das röhrenförmige Element (130) in der zweiten Öffnung (112) derart angebracht ist, dass:
ein innerer Abschnitt (131) des röhrenförmigen Elements (130) sich innerhalb der Auslasskammer (117) und in einem Anbringungskontakt mit dem zweiten Abdeckelement befindet, wobei es in der dritten Öffnung (118) aufgenommen ist; und
ein äußerer Abschnitt (132) des röhrenförmigen Elements (130) sich von dem Gehäuse (100) in einer freitragenden Weise erstreckt; und
wobei der innere Abschnitt (131) des röhrenförmigen Elements (130) eine Vielzahl von Öffnungen (136) zur Beförderung eines Flüssigkeitsstroms in ein Inneres des röhrenförmigen Elements (130) umfasst, wobei die Vielzahl von Öffnungen um beides, (a) um einen Umfang des inneren Abschnitts (131) des röhrenförmigen Elements (130) und (b) entlang einer axialen Länge des inneren Abschnitts (131) des röhrenförmigen Elements (130) verteilt ist,
wobei das röhrenförmige Element (130) ein erstes offenes Ende (133), das den Auslass bildet, und ein zweites Ende (134) umfasst, das durch eine Endkappe (135) verschlossen ist, die verhindert, dass Flüssigkeit aus dem röhrenförmigen Element (130) austritt.

2. Emissionsreinigungsmodul (1) nach Anspruch 1, wobei das Gehäuse (110) eine sich verjüngende Form aufweist, die ein großes Ende und ein kleines Ende definiert; wobei sich die erste Öffnung (111) an dem großen Ende befindet und die zweite Öffnung (112) sich an dem kleinen Ende befindet.

3. Emissionsreinigungsmodul (1) nach Anspruch 1 oder Anspruch 2, wobei beide, die erste Öffnung (111) und die zweite Öffnung (112) in einer ersten Fläche des Gehäuses (110) vorgesehen sind.

4. Emissionsreinigungsmodul (1) nach einem der vorstehenden Ansprüche, weiter ein Klemmelement (150) zum Klemmen des Auslassmoduls an ein Emissionsreinigungsmodul (1) umfassend.

5. Emissionsreinigungsmodul (1) nach einem der vorstehenden Ansprüche, wobei das Gehäuse (110) eines oder mehrere der Folgenden umfasst:
(a) eine W-förmige Versteifungsnut (124);
(b) eine U-förmige Versteifungsnut; und
(c) ein Paar von beabstandeten U-förmigen Versteifungsnuten.

6. Emissionsreinigungsmodul (1) nach einem der vorstehenden Ansprüche, wobei das Gehäuse (110) einen Anbringungsflansch (140) umfasst, der an das Emissionsreinigungsmodul (1) geschweißt ist.

7. Emissionsreinigungsmodul (1) nach einem der vorstehenden Ansprüche, das weiter ein Klemmelement (150) umfasst, das das Auslassmodul (100) an dem Emissionsreinigungsmodul (1) klemmt.

8. Emissionsreinigungsmodul (1) nach einem der vorstehenden Ansprüche, weiter ein weiteres röhrenförmiges Element umfassend, das am Auslass des Gehäuses verbunden ist, wobei das weitere röhrenförmige Element parallel zu einer Leitung (10, 20, 30) des Emissionsreinigungsmoduls (1) ausgerichtet ist.

9. Emissionsreinigungsmodul (1) nach einem der vorstehenden Ansprüche, wobei sich ein Hitzeschild (160) auf dem Emissionsreinigungsmodul (1) befindet, das über dem Auslassmodul (100) liegt; und wobei ein Abschnitt des Auslassmoduls (100), der zumindest einen Abschnitt des röhrenförmigen Elements (130) einschließt, zur Außenseite des Hitzeschilds (160) vorragt.

10. Abgasanlage umfassend das Emissionsreinigungsmodul (1) nach einem der vorstehenden Ansprüche und eine Sektion einer externen Rohrleitung, wobei das weitere röhrenförmige Element ohne andere physische Unterstützung freitragend an dem Auslassmodul (100) angebracht ist.

## Revendications

1. Module de purification d'émissions (1) pour un moteur à combustion, le module de purification d'émissions comprenant un module de sortie (100) comportant une sortie (133) fournissant une sortie de fluide du module de purification d'émissions (1), le module de sortie (100) comprenant :
i) un boîtier (110) constitué d'un premier organe de recouvrement (122) et d'un deuxième organe de recouvrement (123) reliés l'un à l'autre pour définir une chambre de sortie (117), le premier organe de recouvrement (122) du boîtier (100) étant pourvu d'une première ouverture (111) formant une entrée du module de sortie et une deuxième ouverture (112) ; et le deuxième organe de recouvrement (123) étant pourvu d'une troisième ouverture (118) ; et
ii) un organe tubulaire (130) formant une sortie du module de sortie ;
dans lequel l'organe tubulaire (130) est monté dans la deuxième ouverture (112) de sorte que :
une portion interne (131) de l'organe tubulaire (130) est située à l'intérieur de la chambre de sortie (117) et est en contact de montage avec le deuxième organe de recouvrement, dans lequel elle est reçue à l'intérieur de la troisième ouverture (118) ; et
une portion externe (132) de l'organe tubulaire (130) s'étend depuis le boîtier (100) en porte-à-faux ; et
dans lequel la portion interne (131) de l'organe tubulaire (130) comprend une pluralité d'ouvertures (136) pour transporter un flux de fluide dans un intérieur de l'organe tubulaire (130) et dans lequel la pluralité d'ouvertures sont réparties à la fois (a) autour d'une circonférence de la portion interne (131) de l'organe tubulaire (130) et (b) le long d'une longueur axiale de la portion interne (131) de l'organe tubulaire (130),
dans lequel l'organe tubulaire (130) comprend une première extrémité ouverte (133) formant la sortie et une deuxième extrémité (134) qui est fermée par un capuchon d'extrémité (135) empêchant toute sortie de fluide de l'organe tubulaire (130).

2. Module de purification d'émissions (1) selon la revendication 1, dans lequel le boîtier (110) présente une forme effilée définissant une grande extrémité et une petite extrémité ; dans lequel la première ouverture (111) est située à la grande extrémité et la deuxième ouverture (112) est située à la petite extrémité.

3. Module de purification d'émissions (1) selon la revendication 1 ou la revendication 2, dans lequel la première ouverture (111) et la deuxième ouverture (112) sont prévues dans une première face du boîtier (110).

4. Module de purification d'émissions (1) selon l'une quelconque des revendications précédentes, comprenant en outre un organe de fixation (150) pour fixer le module de sortie sur un module de purification d'émissions (1).

5. Module de purification d'émissions (1) selon l'une quelconque des revendications précédentes, dans lequel le boîtier (110) comprend une ou plusieurs de :
(a) une rainure de raidissement en forme de W (124) ;
(b) une rainure de raidissement en forme de U ; et
(c) une paire de rainures de raidissement en forme de U espacées l'une de l'autre.

6. Module de purification d'émissions (1) selon l'une quelconque des revendications précédentes, dans lequel le boîtier (110) comprend une bride de montage (140) qui est soudée sur le module de purification d'émissions (1).

7. Module de purification d'émissions (1) selon l'une quelconque des revendications précédentes, comprenant en outre un organe de fixation (150) qui fixe le module de sortie (100) sur le module de purification d'émissions (1).

8. Module de purification d'émissions (1) selon l'une quelconque des revendications précédentes, comprenant en outre un organe tubulaire supplémentaire relié à la sortie du boîtier, dans lequel l'organe tubulaire supplémentaire est orienté parallèlement à un conduit (10, 20, 30) du module de purification d'émissions (1).

9. Module de purification d'émissions (1) selon l'une quelconque des revendications précédentes, dans lequel un bouclier thermique (160) est situé sur le module de purification d'émissions (1) en recouvrant le module de sortie (100) ; et dans lequel une portion du module de sortie (100), comprenant au moins une portion de l'organe tubulaire (130), fait saillie à l'extérieur du bouclier thermique (160).

10. Agencement d'échappement comprenant le module de purification d'émissions (1) selon l'une quelconque des revendications précédentes et une section de canalisation externe, dans lequel l'organe tubulaire supplémentaire est monté sur le module de sortie (100) en porte-à-faux sans autre support physique.
